# FASCICULE DE BREVET EUROPEEN

(11) **EP 1 181 698 B1**
(45) Date de publication et mention de la délivrance du brevet: **27.07.2005**
(21) Numéro de dépôt: 00931315.6
(22) Date de dépôt: 19.05.2000
(51) Int. Cl.: H01F 38/30

(54) **CAPTEUR DE COURANT A DEUX POSITIONS DE MONTAGE**
STROMSENSOR MIT ZWEI MONTAGEPOSITIONEN
CURRENT PICK-UP SHOE WITH TWO ASSEMBLY POSITIONS

(30) Priorité: 21.05.1999 FR 9906488
(43) Date de publication de la demande: 27.02.2002
(73) Titulaire: ABB CONTROL, F-69680 Chassieu (FR)
(72) Inventeur: VILAS-BOAS, Armando, F-69800 Saint Priest (FR)
(74) Mandataire: Laget, Jean-Loup
(86) Numéro de dépôt international: PCT/FR2000/001360
(87) Numéro de publication internationale: WO 2000/072339

(56) Documents cités:
- FR-A- 1 116 512

## Description

La présente invention concerne un capteur de courant pouvant être fixé soit debout, soit couché à plat sur une surface de support, du type comprenant un boîtier qui présente un premier jeu de passages pour des vis de fixation, dont les axes sont perpendiculaires à une grande face du boîtier pour sa fixation à plat sur la surface de support, un second jeu de passages pour des vis de fixation, dont les axes sont perpendiculaires à ceux du premier jeu de passages de vis, étant prévu pour la fixation du boîtier debout sur ladite surface de support.

Dans les capteurs de courant connus de ce type, les passages de vis sont habituellement constitués par des encoches ou des trous circulaires percés dans des pattes de fixation formées d'un seul tenant avec le boîtier du capteur et faisant saillie sur différents côtés de celui-ci. Les encoches ou les trous circulaires qui constituent le premier jeu de passages de vis sont usuellement formés dans un premier jeu de pattes de fixation qui sont situées dans un premier plan, tandis que les encoches ou les trous circulaires constituant le second jeu de passages de vis sont formés dans un second jeu de pattes de fixation qui sont situées dans un second plan perpendiculaire au premier plan.

Les capteurs de courant de ce type offrent l'avantage de pouvoir être montés dans l'une ou l'autre de deux positions différentes sur la surface de support. Par contre, lorsque le capteur de courant est monté sur la surface de support, les pattes de fixation non utilisées augmentent l'encombrement du capteur de courant. Ceci peut constituer une contrainte gênante pour l'intégration du capteur de courant dans des systèmes dont on exige une certaine compacité.

Par ailleurs, on connaît des capteurs de courant dont le boîtier ne permet qu'un seul mode de montage (debout ou couché). Ces derniers capteurs de courant ont généralement un encombrement moindre que celui des capteurs de courant à deux modes ou positions de montage. Par contre, lorsqu'un utilisateur souhaite avoir la possibilité d'intégrer un capteur de courant dans divers systèmes soit dans la position debout, soit dans la position couchée, en fonction de ses besoins, il doit avoir alors en stock deux types de capteurs de courant. Ceci complique donc la gestion des stocks et la maintenance, et augmente également le coût des stocks.

La présente invention a donc pour but de remédier à cet inconvénient, en fournissant un capteur de courant qui peut être monté indifféremment debout ou couché, et qui est particulièrement compact, en particulier lorsqu'il est monté couché.

A cet effet, le capteur de courant selon l'invention est caractérisé en ce qu'il comprend en outre au moins un élément auxiliaire de bridage qui est adjoint au boîtier et assemblé à lui avec complémentarité de forme uniquement pour la fixation du boîtier debout sur la surface de support, et dans lequel est formé ledit second jeu de passages de vis.

Dans ces conditions, lorsque le capteur de courant est monté couché sur la surface de support, c'est-à-dire sans l'élément auxiliaire de bridage, aucune patte de fixation non utilisée ne fait saillie sur le boîtier du capteur, de sorte que celui-ci est très compact. D'un autre côté, lorsque le capteur de courant est monté en position debout, seules les pattes de fixation qui sont nécessaires pour ce mode de montage font saillie sur le boîtier, de sorte que, là encore, le capteur de courant reste relativement compact. L'utilisateur peut ainsi choisir d'assembler ou de ne pas assembler l'élément auxiliaire de bridage au boîtier du capteur en fonction de ses besoins, de sa gestion de stock et de la maintenance. Même si, pour avoir ce choix, l'utilisateur doit avoir en stock deux pièces distinctes, à savoir d'une part le capteur de courant et d'autre part l'élément auxiliaire de bridage, cette dernière pièce est usuellement une pièce beaucoup moins coûteuse que le capteur de courant proprement dit. En conséquence, le coût du stock est réduit par rapport au cas où l'utilisateur devait disposer de deux types distincts de capteurs de courant à mode de montage unique.

Le capteur de courant selon l'invention peut en outre représenter les caractéristiques suivantes :
- l'élément auxiliaire de bridage est constitué par un flasque ayant une face interne qui s'applique contre une grande face du boîtier du capteur de courant, et une face externe qui porte, sur un bord, deux pattes espacées de fixation qui s'étendent à angle droit vers l'extérieur par rapport à ladite face externe et dans chacune desquelles est formé un desdits passages de vis du second jeu :

- à chaque patte de fixation du flasque sont associées deux goussets triangulaires de renfort, qui sont disposés de part et d'autre du passage de vis correspondant de la patte de fixation ;
- la face interne du flasque porte au moins deux tenons positionnés et dimensionnés pour s'emboîter, avec un faible jeu, chacun dans un des passages de vis du premier jeu de passages dé vis du boîtier ;
- ladite grande face du boîtier contre laquelle s'applique le flasque a une forme rectangulaire, ledit premier jeu de passages de vis comprend quatre passages situés aux angles de ladite grande face, et la face interne dudit flasque porte quatre tenons emboîtables chacun dans un passage respectif du boîtier ;
- dans un mode préféré de réalisation de l'invention, le capteur de courant comprend deux éléments auxiliaires de bridage sous la forme de deux flasques qui sont appliqués respectivement contre des grandes faces opposées du boîtier ;
- les deux flasques peuvent alors être constituées par des pièces moulées identiques ;
- deux des quatre tenons de chaque flasque ont un trou cylindrique étagé, dont la partie de plus grand diamètre débouche du côté de la face externe du flasque et forme un logement pour la tête d'une vis autotaraudeuse, et les deux tenons restants de chaque flasque ont un avant-trou cylindrique dans lequel peut être vissée une vis autotaraudeuse dont la tête se trouve dans la partie formant logement du trou étagé de l'un des deux tenons avec trou étagé du flasque opposé ;
- chaque passage de vis du premier jeu de passages de vis est constitué par un puits qui traverse le boîtier d'une grande face à l'autre et qui présente en son milieu une cloison qui est percée d'un trou pour le passage de la tige d'une vis de fixation ;
- comme cela est usuel, le boîtier comporte une ouverture de passage pour un conducteur primaire parcouru par un courant électrique à mesurer ; le ou les flasque(s) comporte(nt) alors une ouverture qui, lorsque le flasque est adjoint au boîtier, coïncide avec l'ouverture du boîtier, et un collet qui est formé d'un seul tenant avec le flasque, sur sa face externe, et qui entoure l'ouverture du flasque pour supporter ledit conducteur primaire ;
- dans un autre mode de réalisation de l'invention, ledit élément auxiliaire de bridage est constitué par un arceau qui entoure le boîtier sur trois côtés de celui-ci et dont chaque jambe est pourvue, à son extrémité, d'une patte de fixation dans laquelle est formé un des passages de vis dudit second jeu de passages de vis.

L'invention concerne également un flasque de bridage pour capteur de courant, ledit flasque étant caractérisé en ce qu'il est conformé pour être assemblé avec complémentarité de forme au boîtier dudit capteur de courant en vue de la fixation dudit boîtier debout sur ladite surface de support, et en ce que ledit second jeu de passages de vis est formé dans ledit flasque de bridage.

D'autres caractéristiques et avantages de l'invention ressortiront au cours de la description suivante, donnée à titre d'exemple, en référence aux dessins annexés sur lesquels :
- la figure 1 est une vue en perspective éclatée montrant un capteur de courant selon un premier mode de réalisation de l'invention ;
- la figure 2 est une vue en perspective du capteur de courant de la figure 1, à l'état assemblé, c'est-à-dire dans sa configuration pour un montage debout;
- la figure 3 est une vue en perspective du capteur de courant de la figure 1, sans les flasques auxiliaires de bridage, c'est-à-dire dans sa configuration pour un montage couché ;
- la figure 4 est une vue en coupe verticale du capteur de courant, dans l'état assemblé de la figure 2, la coupe passant par deux passages de vis alignés verticalement et étant déportée de façon à passer également par l'ouverture centrale de passage du conducteur primaire, comme indiqué par la ligne brisée IV-IV dans la figure 2 ;
- la figure 5 est une vue semblable à la figure 4, montrant une variante de réalisation n'utilisant qu'un seul flasque pour le montage du capteur de courant, la figure 5 montrant en outre dans ses parties inférieure et supérieure, respectivement, un premier et un second type de vis utilisable pour la fixation du flasque au boîtier du capteur ;
- la figure 6 est une vue en perspective montrant un autre mode de réalisation d'un élément auxiliaire de bridage utilisable pour fixer le boîtier du capteur de courant en position debout à une surface de support.

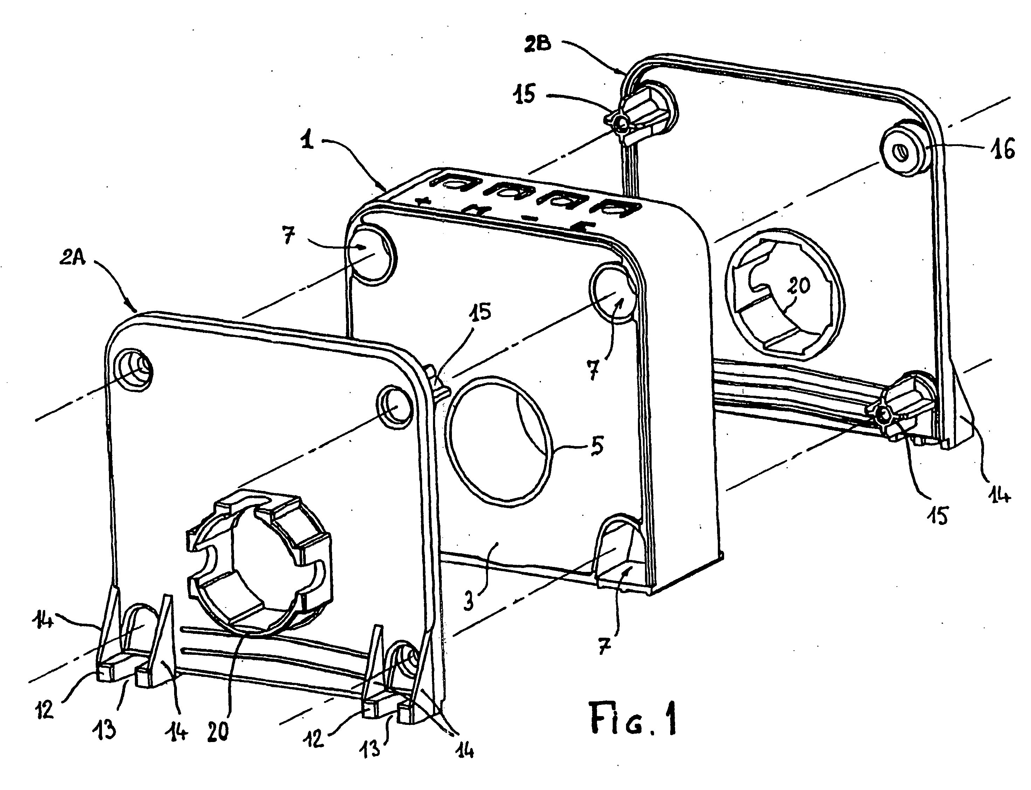

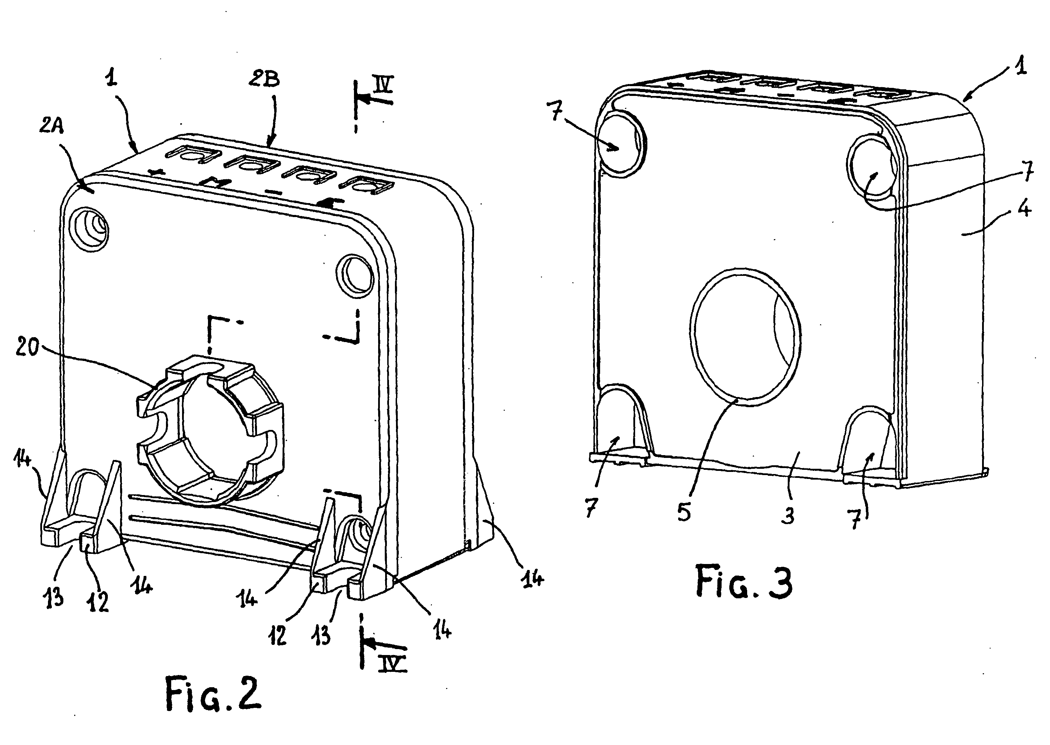

En se référant tout d'abord aux figures 1 et 2, on peut voir que le capteur de courant selon l'invention comprend un boîtier 1 et deux flasques 2A et 2B permettant de fixer le boîtier 1 dans une position debout sur une surface de support (non montrée). Les deux flasques 2A et 2B sont représentées à l'état détaché du boîtier 1 dans la figure 1 et à l'état assemblé au boîtier 1 dans la figure 2.

Le boîtier 1 a en gros une forme parallélépipédique comme montré dans la figure 3. Il est constitué par un corps de boîte ayant une paroi de fond 3 qui, dans l'exemple représenté, a un contour approximativement carré ou légèrement rectangulaire, avec deux angles arrondis, et une paroi périphérique 4, qui entoure la paroi de fond 3 sur ses quatre côtés. La paroi de fond 3 forme l'une des deux grandes faces parallèles et sensiblement planes du boîtier 1, l'autre grande face n'étant pas visible dans la figure 3.

Un manchon cylindrique 5, dont l'axe est perpendiculaire à la paroi de fond 3, est formé d'un seul tenant avec cette dernière, sensiblement au milieu de celle-ci ou dans une position légèrement excentrée par rapport à son milieu comme montré dans la figure 3. Le manchon cylindrique 5 s'étend depuis la paroi de fond 3 jusqu'à l'autre grande face du boîtier 1 et, en service, il entoure usuellement un conducteur ou une barre omnibus (conducteur primaire) parcouru par un courant électrique à mesurer.

Le boîtier 1 ainsi constitué contient usuellement les éléments fonctionnels du capteur de courant, à savoir un circuit magnétique annulaire, qui porte une bobine de mesure (enroulement secondaire) et qui est placé autour du manchon cylindrique 5, ainsi qu'un circuit électronique de mesure, qui est porté par exemple par une plaquette à circuit imprimé et qui est connecté à la bobine précitée. Le circuit magnétique et sa bobine ainsi que le circuit électronique peuvent être réalisés de manière classique et, comme ils ne sont pas nécessaires à la compréhension de l'invention, ils ne seront donc pas décrits en détail.

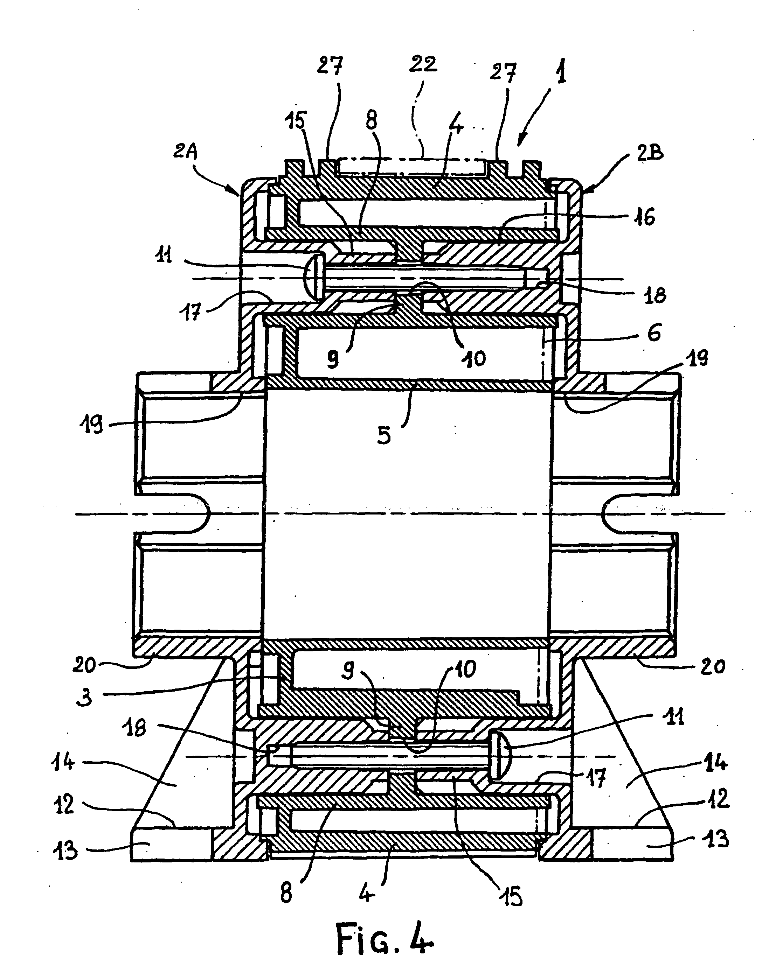

Le corps du boîtier 1 contenant les éléments fonctionnels indiqués ci-dessus du capteur de courant peut être obturé par un couvercle (non montré) ou, plus simplement, après mise en place desdits éléments fonctionnels dans le corps du boîtier, les espaces de vide de celui-ci peuvent être remplis d'une résine qui, après durcissage, forme l'autre grande face du boîtier 1 comme indiqué en traits mixtes en 6 dans la figure 4.

Comme montré dans la figure 3, le boîtier 1 comporte quatre passages 7 pour des vis de fixation. Les passages 7 ont des axes parallèles à l'axe du manchon cylindrique 5 et sont situés dans la région des angles de la paroi de fond 3. Comme cela est plus particulièrement visible dans la figure 4, chaque passage 7 peut être constitué par un puits 8, qui est formé d'un seul tenant avec la paroi de fond 3 et qui traverse le boîtier 1 d'une grande face à l'autre de celui-ci. Chaque puits 8 présente, en son milieu, une cloison 9 qui est percée d'un trou 10, dont le diamètre est un peu plus grand que celui de la tige d'une vis de fixation 11.

Le boîtier 1 décrit ci-dessus, qui contient les éléments fonctionnels du capteur de courant, peut être fixé en position couchée sur une surface de support (non montrée), c'est-à-dire avec ses deux grandes faces 3 et 6 parallèles à la surface de support. Dans ce cas, les deux flasques 2A et 2B ne sont pas utilisés et les vis de fixation 11 sont engagées dans les passages 7, à partir d'un même côté du boîtier 1, puis passées à travers les trous 10 des cloisons 9 et vissées dans des trous taraudés appropriés prévus dans la surface de support. Dans ce cas, les tétes des vis 11 viennent en appui contre une des faces des cloisons 9 pour presser le boîtier 1 contre la surface de support.

Les deux flasques 2A et 2B sont utilisées uniquement lorsque le capteur de courant doit être monté en position debout sur une surface de support. Les deux flasques 2A et 2B sont constituées de préférence par des pièces moulées identiques. Dans l'exemple représenté ici, chaque flasque 2A, 2B présente un contour carré ou légèrement rectangulaire épousant la forme du contour du boîtier 1 ou de sa paroi de fond 3.

La face externe de chaque flasque 2A, 2B, c'est-à-dire la face qui tourne le dos au boîtier 1, porte, sur un bord, deux pattes espacées de fixation 12 qui s'étendent à angle droit vers l'extérieur par rapport à ladite face externe.

Dans chaque patte 12 est formée une encoche 13 apte à recevoir une vis de fixation (non montrée) permettant la fixation du flasque 2A ou 2B en position debout sur une surface de support. A la place des encoches 13, on pourrait bien entendu prévoir des trous circulaires ou des trous oblongs. De préférence, chaque patte de fixation 12 est renforcée par deux goussets triangulaires 14, qui sont disposés de part et d'autre de l'encoche 13.

La face interne de chaque flasque 2A, 2B, c'est-à-dire la face qui est orientée vers le boîtier, porte au moins deux tenons 15, 16, de préférence deux paires de tenons 15, 16, qui sont positionnés et dimensionnés pour s'emboîter, avec un faible jeu, chacun dans un des passages 7 du boîtier 1.

Les deux tenons 15 de chaque flasque 2A, 2B se trouvent dans des angles du flasque correspondant à une première diagonale de la forme carrée ou rectangulaire du flasque, tandis que les deux autres tenons 16 sont situés dans les angles du flasque correspondant à la seconde diagonale de sa forme carrée ou rectangulaire. Dans ces conditions, lorsque les deux flasques 2A et 2B sont appliqués respectivement contre les grandes faces opposées du boîtier 1 et que leurs tenons 15, 16 sont engagés dans les passages 7 du boîtier, chaque tenon 15 du flasque 2A ou 2B est aligné avec un tenon 16 du flasque 2B ou 2A dans le passage 7 correspondant, comme montré dans la figure 4.

Chaque tenon 15 a un trou cylindrique étagé 17, dont la partie de plus grand diamètre débouche du côté de la face externe du flasque 2A ou 2B et forme un logement pour la tête de l'une des vis de fixation 11. D'autre part, chaque tenon 16 de chaque flasque 2A ou 2B a un trou cylindrique 18 dans lequel peut être vissée la tige filetée de l'une des vis de fixation 11. Bien que le trou 18 pourrait être un trou fileté intérieurement, il est plus simple et plus économique de réaliser les trous 18 sous la forme de trous cylindriques lisses et d'utiliser des vis autotaraudeuses comme vis de fixation 11.

De préférence, les tenons 15 et 16 ont des longueurs telles que leurs extrémités frontales viennent en appui contre les faces opposées des cloisons 9 dans les puits 8 du boîtier 1 après qu'ils ont été engagés dans lesdits puits et que les vis 11 ont été vissées à fond dans les trous 18 des tenons 16.

Une fois que les deux flasques 2A et 2B ont été ainsi assemblées au boîtier 1, on obtient un ensemble capteur de courant, qui est particulièrement rigide et qui peut être monté debout sur une surface de support (non montré), en plaçant les pattes de fixation 12 contre ladite surface de support et en disposant leurs encoches 13 en regard de trous appropriés prévus dans la surface de support. L'ensemble capteur de courant (boîtier 1 + flasques 2A et 2B) peut être alors fixé à la surface de support à l'aide de vis appropriées passant dans les encoches 13 et dans les trous susmentionnés de la surface de support.

Bien entendu, chaque flasque 2A, 2B comporte une ouverture de passage 19 pour le conducteur primaire parcouru par le courant à mesurer, cette ouverture 19 étant alignée avec le manchon cylindrique 5 du boîtier 1 comme cela est clairement visible dans la figure 4. Dans le cas où le capteur de courant doit pouvoir guider et supporter une barre omnibus (non montrée) servant de conducteur primaire, chaque flasque 2A, 2B peut avantageusement comporter un collet 20, qui est formé d'un seul tenant avec le flasque, sur sa face externe, autour de l'ouverture 19.

Dans l'exemple de réalisation qui a été décrit ci-dessus, on utilise deux flasques 2A et 2B pour la fixation du capteur de courant dans une position debout sur une surface de support. Une telle réalisation convient particulièrement bien lorsque le capteur de courant est susceptible d'être soumis, en service, à des vibrations ou à d'autres efforts, statiques ou dynamiques, qui peuvent atteindre des valeurs importantes.

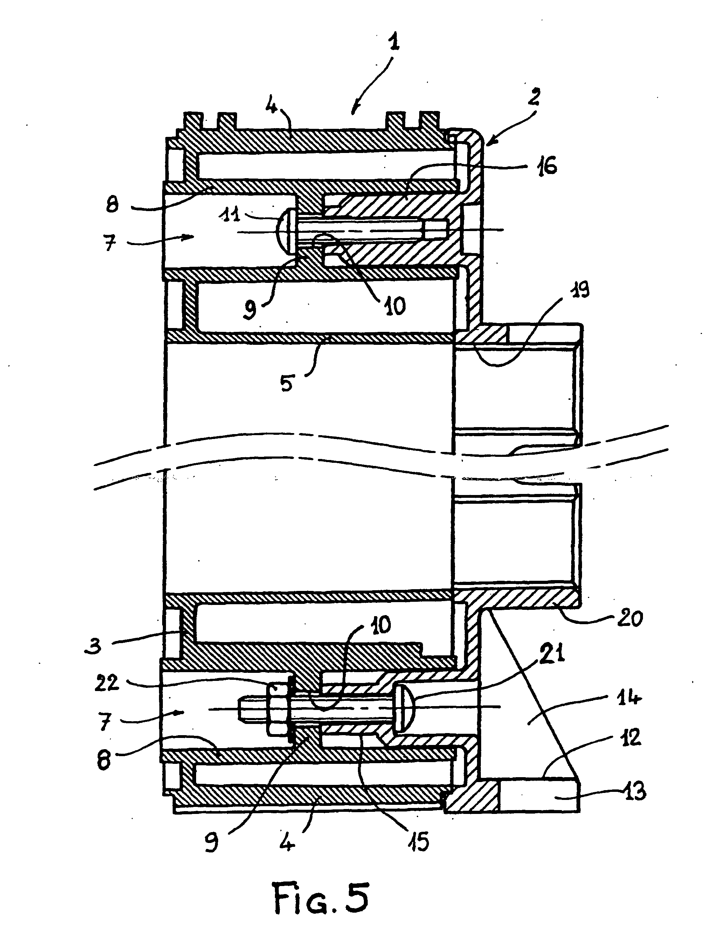

Toutefois, l'invention n'est pas limitée à une telle réalisation. En effet, si le flasque 2A ou 2B est réalisé en une matière plastique suffisamment rigide, éventuellement renforcée par des charges telles que des fibres, et/ou si le capteur de courant n'est pas soumis en service à des vibrations ou à d'autres efforts statiques ou dynamiques importants, un seul flasque 2A ou 2B peut suffire pour le montage en position debout du capteur de courant. Ce cas est représenté dans la figure 5, dans laquelle les éléments qui sont identiques ou qui jouent le même rôle que les éléments du mode de réalisation décrit précédemment sont désignés par les mêmes numéros de référence et ne seront pas décrits à nouveau en détail. Dans la variante de réalisation de la figure 5, l'unique flasque 2 peut encore avoir sur sa face interne quatre tenons, à savoir deux tenons 15 et deux tenons 16. Dans ce cas, chaque tenon 15 est fixé à la paroi transversale 9 du puits 8 correspondant du boîtier 1 par un ensemble vis 21 et écrou 22, tandis que chaque tenon 16 est fixé à la cloison transversale correspondante 9 par une vis autotaraudeuse 11 semblable à celle du mode de réalisation précédent, mais plus courte.

Dans une autre variante de réalisation, pour éviter d'avoir à utiliser des vis 11 et 21 de types différents, les quatre tenons du flasque 2 pourraient être identiques. Dans ce cas, les quatre tenons peuvent être semblables ou bien aux tenons 15 montrés dans la partie inférieure de la figure 5, ou bien aux tenons 16 montrés dans la partie supérieure de la figure 5.

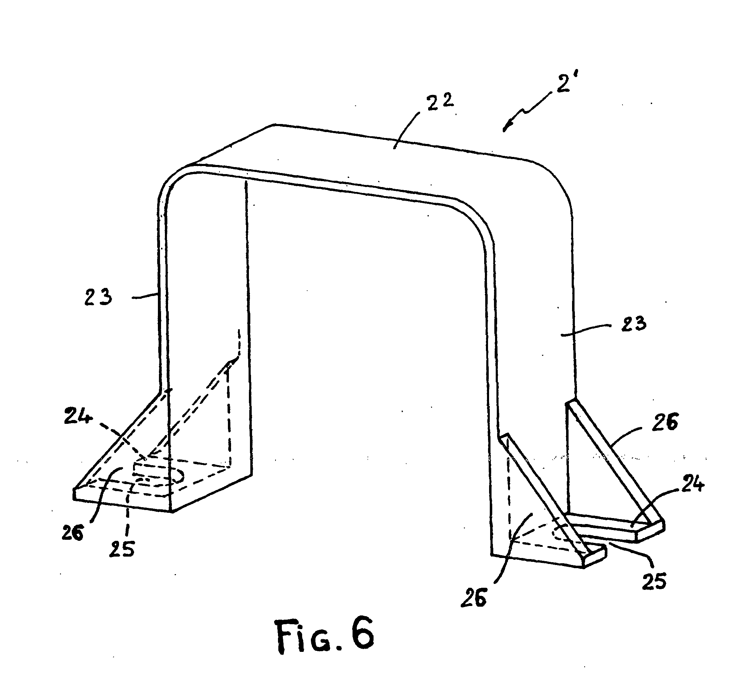

La figure 6 montre un autre mode de réalisation d'un élément auxiliaire de bridage 2' pouvant être utilisé à la place du flasque 2 de la figure 5 ou des deux flasques 2A et 2B des figures 1, 2 et 4, pour le montage en position debout du boîtier 1 de la figure 3 sur une surface de support. L'élément auxiliaire de bridage 2' représenté dans la figure 6 se présente sous la forme d'un arceau 22 conformé de manière à pouvoir entourer étroitement le boîtier 1 de la figure 3, sur trois côtés de ce boîtier. Chaque jambe 23 de l'arceau 22 est pourvue, à son extrémité inférieure, d'une patte de fixation 24 ayant une ouverture de passage 25 pour une vis de fixation (non montrée). L'ouverture 25 ici représentée est constituée par une encoche, mais elle pourrait tout aussi bien être constituée par un trou circulaire ou oblong. Chaque patte de fixation 25 peut être avantageusement renforcée par deux goussets triangulaires 26.

Dans le cas où la paroi périphérique 4 du boîtier 1 possède des nervures 27 comme montré dans la figure 4, la largeur de l'arceau 22 peut être choisie de manière à correspondre à l'espacement des nervures 27. Dans ce cas, l'arceau 22 peut coopérer avec les nervures 27 pour empêcher tout mouvement du boîtier 1 dans une direction parallèle à l'axe du manchon cylindrique 5, même si l'arceau 22 n'est pas parfaitement serré contre la paroi périphérique 4 du boîtier.

Il va de soi que les modes de réalisation de l'invention qui ont été décrits ci-dessus ont été donnés à titre d'exemple purement indicatif et nullement limitatif, et que de nombreuses modifications peuvent être apportées par l'homme de l'art sans pour autant sortir du cadre de l'invention. C'est ainsi que les quatre tenons des deux flasques 2A et 2B pourraient être semblables aux tenons 15 décrits plus haut. Dans ce cas, les deux flasques 2A et 2B peuvent être assemblés au boîtier 1 par des ensembles boulon et écrou semblables à celui qui est montré dans le bas de la figure 5, les boulons étant cependant plus longs que celui qui est montré dans cette figure.

Dans une autre variante de réalisation, la fixation du ou des flasques au boîtier pourrait être obtenue par clipsage. Par exemple, dans le cas où il est prévu deux flasques, deux des quatre tenons de chaque flasque peuvent être réalisés sous la forme de tenons mâles munis d'ergots d'encliquetage pouvant s'enclencher derrière un épaulement annulaire d'un trou cylindrique étagé formé dans chacun des deux autres tenons, comme le trou 17 des tenons 15 décrits plus haut.

## Revendications

1. Capteur de courant pouvant être fixé soit debout, soit couché à plat sur une surface de support, comprenant un boîtier (1) qui présente un premier jeu de passages (7) pour des vis de fixation (11), dont les axes sont perpendiculaires à une grande face (3) du boîtier (1) pour sa fixation à plat sur la surface de support, un second jeu de passages (13 ; 25) pour des vis de fixation, dont les axes sont perpendiculaires à ceux du premier jeu de passages de vis (7), étant prévu pour la fixation du boîtier (1) debout sur ladite surface de support, **caractérisé en ce qu'**il comprend en outre au moins un élément auxiliaire de bridage (2 ; 2A, 2B ; 2') qui est adjoint au boîtier (1) et assemblé à lui avec complémentarité de forme uniquement pour la fixation du boîtier debout sur la surface de support, et dans lequel est formé ledit second jeu de passages de vis (13 ; 25).

2. Capteur de courant selon la revendication 1, **caractérisé en ce que** ledit élément auxiliaire de bridage (2) est constitué par un flasque ayant une face interne qui s'applique contre une grande face de boîtier (1) du capteur de courant, et une face externe qui porte, sur un bord, deux pattes espacées de fixation (12) qui s'étendent à angle droit vers l'extérieur par rapport à ladite face externe et dans chacune desquelles est formé un desdits passages de vis (13) du second jeu.

3. Capteur de courant selon la revendication 2, **caractérisé en ce que** à chaque patte de fixation (12) du flasque (2) sont associées deux goussets triangulaires de renfort (14), qui sont disposés de part et d'autre du passage de vis correspondant (13) de la patte de fixation (12).

4. Capteur de courant selon la revendication 2 ou 3, **caractérisé en ce que** la face interne du flasque (2) porte au moins deux tenons (15, 16) positionnés et dimensionnés pour s'emboîter, avec un faible jeu, chacun dans un des passages de vis (7) du premier jeu de passages de vis du boîtier (1).

5. Capteur de courant selon la revendication 4, **caractérisé en ce que** ladite grande face du boîtier (1) contre laquelle s'applique le flasque (2) a une forme rectangulaire, **en ce que** ledit premier jeu de passages de vis (7) comprend quatre passages situés aux angles de ladite grande face, et **en ce que** la face interne dudit flasque porte quatre tenons (15, 16) emboîtables chacun dans un passage (7) respectif du boîtier (1).

6. Capteur de courant selon la revendication 5, **caractérisé en ce qu'**il comprend deux éléments auxiliaires de bridage (2A, 2B) sous la forme de deux flasques qui sont appliqués respectivement contre des grandes faces opposées du boîtier (1).

7. Capteur de courant selon la revendication 6, **caractérisé en ce que** les deux flasques (2A, 2B) sont constitués par des pièces moulées identiques.

8. Capteur de courant selon la revendication 7, **caractérisé en ce que** deux (15) des quatre tenons (15, 16) de chaque flasque (2A, 2B) ont un trou cylindrique étagé (17), dont la partie de plus grand diamètre débouche du côté de la face externe du flasque (2A, 2B) et forme un logement pour la tête d'une vis autotaraudeuse (11), et **en ce que** les deux tenons (16) restants de chaque flasque (2A, 2B) ont un avant-trou cylindrique (18) dans lequel peut être vissée une vis autotaraudeuse (11) dont la tête se trouve dans la partie formant logement du trou étagé (17) de l'un des deux tenons (15) avec trou étagé du flasque opposé (2B, 2A).

9. Capteur de courant selon l'une quelconque des revendications 4 à 9, **caractérisé en ce que** chaque passage de vis (7) du premier jeu de passages de vis est constitué par un puits (8) qui traverse le boîtier (1) d'une grande face (3) à l'autre (6) et qui présente en son milieu une cloison (9) qui est percée d'un trou (10) pour le passage de la tige d'une vis de fixation (11).

10. Capteur de courant selon l'une quelconque des revendications 2 à 9, dans lequel le boîtier (1) comporte une ouverture de passage (5) pour un conducteur primaire parcouru par un courant électrique à mesurer, **caractérisé en ce que** le ou les flasque(s) (2 ; 2A, 2B) comporte(nt) une ouverture (19) qui, lorsque le flasque est adjoint au boîtier, coïncide avec l'ouverture (5) du boîtier (1), et un collet (20) qui est formé d'un seul tenant avec le flasque, sur sa face externe, et qui entoure l'ouverture (19) du flasque pour supporter ledit conducteur primaire.

11. Capteur de courant selon la revendication 1, **caractérisé en ce que** ledit élément auxiliaire de bridage (2') est constitué par un arceau (22) qui entoure le boîtier (1) sur trois côtés de celui-ci et dont chaque jambe (23) est pourvue, à son extrémité, d'une patte de fixation (24) dans laquelle est formé un des passages de vis (25) dudit second jeu de passages de vis.

12. Flasque de bridage destiné à être utilisé comme élément auxiliaire de bridage avec le capteur de courant selon l'une quelconque des revendications 1, 2, 3, 4, 5, 8 et 10, **caractérisé en ce qu'**il est conformé pour être assemblé avec complémentarité de forme au boîtier (1) dudit capteur de courant en vue de la fixation dudit boîtier (1) debout sur ladite surface de support, et **en ce que** ledit second jeu de passages de vis (13) est formé dans ledit flasque de bridage (2).

## Patentansprüche

1. Stromsensor, der entweder stehend oder flachliegend auf einer Stützfläche befestigt werden kann, mit einem Gehäuse (1), das einen ersten Satz von Durchlässen (7) für Befestigungsschrauben (11), deren Achsen senkrecht zu einer großen Fläche (3) des Gehäuses (1) sind, für seine flachliegende Befestigung auf der Stützfläche aufweist, wobei ein zweiter Satz von Durchlässen (13; 25) für Befestigungsschrauben, deren Achsen senkrecht zu denen des ersten Satzes von Schraubdurchlässen (7) sind, für die stehende Befestigung des Gehäuses (1) auf der Stützfläche vorgesehen ist, **dadurch gekennzeichnet, dass** er zusätzlich mindestens ein Anflansch-Hilfselement (2; 2A, 2B; 2') aufweist, welches dem Gehäuse (1) zugeordnet und mit diesem formkomplementär zusammengefügt ist, ausschließlich für die stehende Befestigung des Gehäuses auf der Stützfläche, und in welchem der zweite Satz von Schraubdurchlässen (13; 25) ausgebildet ist.

2. Stromsensor nach Anspruch 1, **dadurch gekennzeichnet, dass** das Anflansch-Hilfselement (2) aus einer Flanschscheibe besteht, mit einer Innenfläche, die sich gegen eine große Fläche des Gehäuses (1) des Stromsensors anlegt, und einer Außenfläche, die an einem Rand (2) beabstandete Befestigungslappen (12) trägt, die sich von der Außenfläche im rechten Winkel nach außen erstrecken, wobei in jedem von ihnen einer der Schraubdurchlässe (13) des zweiten Satzes ausgebildet ist.

3. Stromsensor nach Anspruch 2, **dadurch gekennzeichnet, dass** jedem Befestigungslappen (12) der Flanschscheibe (2) zwei dreieckige Verstärkungsstege (14) zugeordnet sind, die beiderseits des Schraubdurchlasses (13) des jeweiligen Befestigungslappens (12) angeordnet sind.

4. Stromsensor nach Anspruch 2 oder 3, **dadurch gekennzeichnet, dass** die Innenfläche der Flanschschcibe (2) mindestens zwei Zapfen (15, 16) trägt, die derart positioniert und bemessen sind, dass sie mit geringem Spiel jeweils in einen der Schraubdurchlässe (7) des ersten Satzes von Schraubdurchlässen des Gehäuses (1) einführbar sind.

5. Stromsensor nach Anspruch 4, **dadurch gekennzeichnet, dass** die große Fläche des Gehäuses (1), gegen die sich die Flanschscheibe (2) anlegt, eine rechteckige Form hat, und dass der erste Satz von Schraubdurchlässen (7) vier Durchlässe aufweist, die an den Ecken der großen Fläche angeordnet sind, und dass die Innenfläche der Flanschscheibe vier Zapfen (15, 16) aufweist, von denen jeder in einen jeweiligen Durchlass (7) des Gehäuses (1) einführbar ist.

6. Stromsensor nach Anspruch 5, **dadurch gekennzeichnet, dass** er zwei Anflansch-Hilfselemente (2A, 2B) aufweist in Form von zwei Flanschscheiben, die jeweils gegen die einander gegenüberliegenden großen Flächen des Gehäuses (1) anliegen.

7. Stromsensor nach Anspruch 6, **dadurch gekennzeichnet, dass** die beiden Flanschscheiben (2A, 28) aus identischen Spritzgussteilen bestehen.

8. Stromsensor nach Anspruch 7, **dadurch gekennzeichnet, dass** zwei (15) der vier Zapfen (15, 16) jeder Flanschscheibe (2A, 2B) ein abgestuftes zylindrisches Loch (17) aufweisen, dessen Abschnitt größeren Durchmessers zur Außenfläche der Flanschscheibe (2A, 2B) ausmündet und einen Sitz für den Kopf einer selbstschneidenden Schraube (11) bildet, und dass die beiden übrigen Zapfen (16) jeder Flanschscheibe (2A, 2B) ein zylindrisches Kernloch (18) aufweisen, in welches eine selbstschneidende Schraube (11) einschraubbar ist, deren Kopf sich in dem einen Sitz bildenden Abschnitt des abgestuften Loches (17) eines der beiden Zapfen (15) mit abgestuftem Loch der gegenüberliegenden Flanschscheibe (2B, 2A) befindet.

9. Stromsensor nach einem der Ansprüche 4 bis 9, **dadurch gekennzeichnet, dass** jeder Schraubdurchlass (7) des ersten Satzes von Schraubdurchlässen gebildet ist durch einen Schacht (8), der sich quer durch das Gehäuse (1) von einer großen Fläche (3) zur anderen (6) erstreckt und der in seiner Mitte eine Verschlusswand (9) aufweist, durch die sich ein Loch (10) für den Durchtritt des Schaftes einer Befestigungsschraube (11) erstreckt.

10. Stromsensor nach einem der Ansprüche 2 bis 9, bei welchem das Gehäuse (1) eine Durchschnittsöffnung (5) für einen Primärleiter aufweist, durch den ein zu messender elektrischer Strom fließt, **dadurch gekennzeichnet, dass** die Flanschscheibe(n) (2; 2A, 2B) eine Öffnung (19) aufweist (aufweisen), die, wenn die Flanschscheibe mit dem Gehäuse verbunden ist, mit der Öffnung (5) des Gehäuses (1) zu Deckung kommt, und einen Kragen (20), der einstückig mit der Flanschscheibe auf deren Außenfläche ausgebildet ist und der die Öffnung (19) der Flanschscheibe umgibt, um den Primärleiter zu stützen.

11. Stromsensor nach Anspruch 1, **dadurch gekennzeichnet, dass** das Anflansch-Hilfselement (2) aus einem Bügel (22) besteht, der das Gehäuse (1) auf drei Seiten umgibt, wobei jeder seiner Schenkel (23) an seinem Ende mit einem Befestigungslappen (24) versehen ist, in welchem einer der Schraubdurchlässe (25) des zweiten Satzes von Schraubdurchlässen ausgebildet ist.

12. Flanschscheibe zur Verwendung als Anflansch-Hilfselement mit dem Strömsensor gemäß einem der Ansprüche 1, 2, 3, 4, 5, 8 und 10, **dadurch gekennzeichnet, dass** sie so ausgebildet ist, dass sie formkomplementär mit dem Gehäuse (1) des Stromsensors zusammengefügt werden kann für die stehende Befestigung des Gehäuses (1) auf der Stützfläche, und dass der zweite Satz von Schraubdurchlässen (13) in der Flanschscheibe (2) ausgebildet ist.

## Claims

1. Current sensor being able to be mounted either upright or lying flat on a support surface, comprising a housing (1) which has a first set of passages (7) for mounting screws (11), the axes of which are perpendicular to one large face (3) of the housing (1) for flat mounting thereof on the support surface, a second set of passages (13; 25) for mounting screws, the axes of which are perpendicular to those of the first set of screw passages (7), being provided for mounting the housing (1) upright on said support surface, **characterised in that** it comprises furthermore at least one auxiliary clamping element (2; 2A, 2B; 2') which is joined to the housing (1) and assembled on it by complementarity of shape only for mounting the housing upright on the support surface, and in which said second set of screw passages (13; 25) is formed.

2. Current sensor according to claim 1, **characterised in that** said auxiliary clamping element (2) is formed by an end plate having an internal face which abuts against one large housing face (1) of the current sensor, and an external face which carries, on one edge, two spaced mounting tabs (12) which extend at a right angle towards the exterior relative to said external face and in each of which there is formed one of said screw passages (13) of the second set.

3. Current sensor according to claim 2, **characterised in that** there are connected to each mounting tab (12) of the end plate (2) two triangular reinforcement gussets (14), which are disposed on both sides of the corresponding screw passage (13) of the mounting tab (12).

4. Current sensor according to claim 2 or 3, **characterised in that** the internal face of the end plate (2) carries at least two studs (15, 16) which are positioned and dimensioned in order each to be fitted, with minor clearance, in one of the screw passages (7) of the first set of screw passages of the housing (1).

5. Current sensor according to claim 4, **characterised in that** said large face of the housing (1), against which the end plate (2) abuts has a rectangular shape, **in that** said first set of screw passages (7) comprises four passages which are situated at the corners of said large face, and **in that** the internal face of said end plate carries four studs (15, 16) which can each be fitted in a respective passage (7) of the housing (1).

6. Current sensor according to claim 5, **characterised in that** it comprises two auxiliary clamping elements (2A, 2B) in the form of two end plates which abut respectively against opposite large faces of the housing (1).

7. Current sensor according to claim 6, **characterised in that** the two end plates (2A, 2B) are formed by identical moulded parts.

8. Current sensor according to claim 7, **characterised in that** two (15) of the four studs (15, 16) of each end plate (2A, 2B) have a stepped cylindrical hole (17), the part with the largest diameter of which opens on the side of the external face of the end plate (2A, 2B) and forms a receiving means for the head of a self-cutting screw (11), and **in that** the two remaining studs (16) of each end plate (2A, 2B) have a cylindrical pilot hole (18) in which there can be screwed a self-cutting screw (11), the head of which is located in the part which forms the receiving means of the stepped hole (17) of one of the two studs (15) with a stepped hole of the opposite end plate (2B, 2A).

9. Current sensor according to any of the claims 4 to 9, **characterised in that** each screw passage (7) of the first set of screw passages is formed by a shaft (8) which traverses the housing (1) from one large face (3) to the other (6) and which has in its centre a partition (9) which is pierced by a hole (10) for the passage of the shaft of a mounting screw (11).

10. Current sensor according to any of the claims 2 to 9, in which the housing (1) comprises a passage opening (5) for a primary conductor in which there flows an electrical current which is to be measured, **characterised in that** the end plate or plates (2; 2A, 2B) comprise(s) an opening (19) which, when the end plate is joined to the housing, coincides with the opening (5) of the housing (1), and a collar (20), which is formed in one piece with the end plate, on its external face, and which surrounds the opening (19) of the end plate in order to support said primary conductor.

11. Current sensor according to claim 1, **characterised in that** said auxiliary clamping element (2') is formed by a hoop (22) which surrounds the housing (1) on three sides of the latter and each leg (23) of which is provided, at its end, with a mounting tab (24) in which there is formed one of the screw passages (25) of said second set of screw passages.

12. Clamping end plate intended to be used as an auxiliary clamping element with the current sensor according to any of the claims 1, 2, 3, 4, 5, 8 and 10, **characterised in that** it is configured in order to be assembled by complementarity of shape on the housing (1) of said current sensor with a view to mounting said housing (1) upright on said support surface, and **in that** said second set of screw passages (13) is formed in said clamping end plate (2).
